# EUROPEAN PATENT SPECIFICATION

(11) **EP 4 231 361 B1**
(45) Date of publication and mention of the grant of the patent: **09.04.2025**
(21) Application number: 23157224.9
(22) Date of filing: 17.02.2023
(51) Int. Cl.: H01L 29/78, H01L 29/417, H01L 21/336, H01L 29/10, H01L 29/40

(54) **METHOD FOR AUTO-ALIGNED MANUFACTURING OF A TRENCH-GATE MOS TRANSISTOR, AND SHIELDED-GATE MOS TRANSISTOR**
VERFAHREN ZUR SELBSTJUSTIERTEN HERSTELLUNG EINES TRENCH-GATE-MOS-TRANSISTORS UND ABGESCHIRMTER GATE-MOS-TRANSISTOR
PROCÉDÉ DE FABRICATION AUTO-ALIGNÉE D'UN TRANSISTOR MOS À GRILLE EN TRANCHÉE ET TRANSISTOR MOS À GRILLE BLINDÉE

(30) Priority: 21.02.2022 IT 202200003125
(43) Date of publication of application: 23.08.2023
(73) Proprietor: STMicroelectronics S.r.l., 20864 Agrate Brianza (MB) (IT); STMicroelectronics Pte Ltd., Singapore 569508 (SG)
(72) Inventor: ENEA, Vincenzo, 96100 Siracusa (IT); NGWAN, Voon Cheng, 732686 Singapore (SG)
(74) Representative: Studio Torta S.p.A.

(56) References cited:
- EP-A2- 1 978 562
- CN-A- 106 129 114
- US-A1- 2011 177 663
- US-A1- 2014 284 708
- US-A1- 2016 218 008
- US-B1- 8 753 935

## Description

The present invention relates to a method for manufacturing a metal oxide semiconductor (MOS) transistor, and to the corresponding a MOS transistor.

As power MOSFET technology advances, cell pitch is reduced to reduce accordingly the overall die size to achieve better Rsil (Rsil is the on-state resistance of the device contributed by silicon, and normalized by area, measured as mΩ·mm²).

Fabricating devices with reduced cell pitch can be challenging, especially when it is limited by photolithography tool capability. Without a good alignment control, electrical parameters and device performances under unclamped inductive switching (UIS) conditions, as well as the threshold voltage (Vth) at which the device turns-on, can be compromised.

Therefore, a self-aligned contact approach (without the need for tight photolithography alignment control) can further improve UIS performance with reduced cell pitch.

UIS degradation can be caused by non-uniform or asymmetrical (with respect to active cell center) body well enrichment below the source/body junction. In fact, this situation can lead to current distribution issues during device switch-off, ultimately leading to UIS failures. This degradation can be amplified with the use of low doping of the body region to achieve a logic-level Vth.

The known solutions to improve UIS capability require to increase the body-well doping by performing an implant step through the source contact. In addition, a dedicated enrichment mask and following implant step, with a dedicated diffusion step (before contacts formations), is used to further increase body-well doping.

Known self-alignment methods are not easily integrated in a trench power MOSFET device, due to the complex process flow required. In fact, known solutions are limited by the mask alignment (both for manufacturing contacts or enrichment) with respect to the active cell center. As discussed above, mask create an asymmetrical doping distribution within the active cell which lead to an unbalanced current flow that degrade UIS performance, which can be worsened with the use of low doping body to achieve logic-level Vth.

Furthermore, with the known techniques, the cell pitch cannot be further and easily reduced. Advanced photolithography tool, such as scanner, must be used, with an increase of costs and manufacturing complexity.

Patent document US2014/284708 relates generally to a semiconductor device and a method for manufacturing the same.

EP1978562 relates to a trench metal-oxide-semiconductor field effect transistor.

US2016/218008 relates to manufacturing processes and structural configurations of improved deep contact trench with reduced critical dimension having shrunken distance between the deep trench contacts.

US8753935 generally relates to metal oxide silicon field effect transistors and more particularly to high density trench based power MOSFETS.

CN106129114 relates to the field of semiconductor devices, and in particular to a trench power device and a method of fabricating the same.

However, the above-mentioned issues are not solved.

The object of the present invention is to provide a method for manufacturing a MOS transistor, and to the corresponding a MOS transistor, to overcome the disadvantages of the known art.

According to the present invention a method for manufacturing a MOS transistor and a MOS transistor as defined in the appended claims are provided.

For a better understanding of the present invention, preferred embodiments of it will now be described, purely by way of a non-limiting example, with reference to the appended drawings, in which:
- Figures 1-14 show in a lateral cross-sectional view (i.e., view on the XZ plane) steps for the manufacturing of a trench-gate MOS transistor according to one embodiment of the present invention; and
- Figures 15-19 illustrate another embodiment for manufacturing a single cell 200 of a MOS transistor.

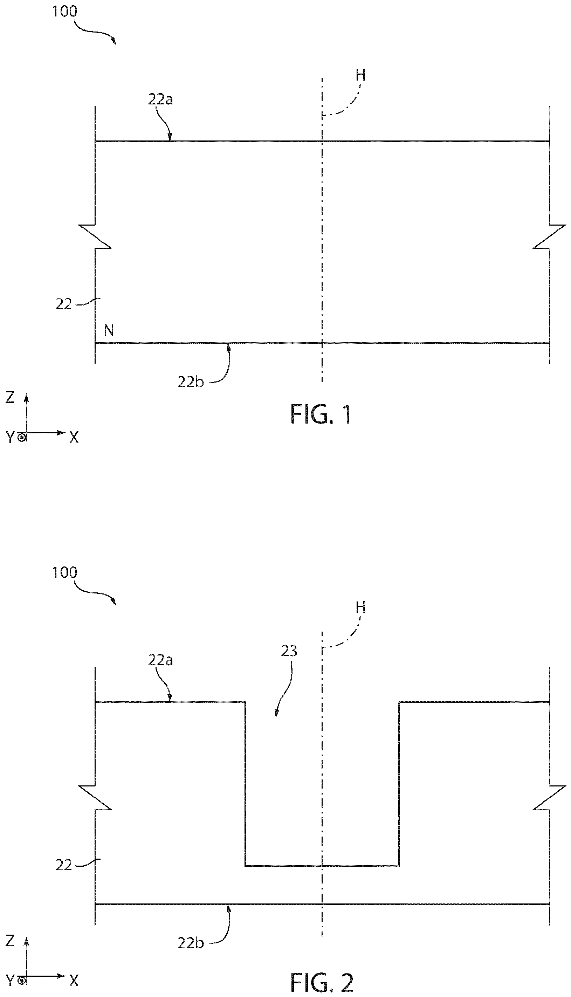

With reference to Figures 1-14, steps for the manufacture of a MOS transistor 21 according to one embodiment of the present invention are described (in particular, as apparent from the present description, a shielded-gate MOS transistor is disclosed). Figures 1-14 show, in particular, a lateral section of a portion of a wafer during subsequent manufacturing steps, in a triaxial reference system having orthogonal X, Y and Z axes. More in particular, figures 1-14 illustrate a single cell 100 of the MOS transistor 21; in general, the MOS transistor 21 comprises a plurality of cells 100, arranged one alongside the other.

With reference to Figure 1, the wafer is provided including a semiconductor body 22 (which may include a substrate and one or more epitaxial layers grown on the substrate). The substrate and the epitaxial layers are of semiconductor material, for example Silicon, having a first conductivity type, in this case N type, and a doping concentration for example between 1·10¹⁶ and 5·10¹⁶ atoms/cm³; the semiconductor body 22 includes a first side 22a and a second side 22b parallel to the X axis. An axis of symmetry H of the cell 100, parallel to the Z axis, is also represented.

Then, Figure 2, a trench 23 is etched in the semiconductor body 22, from the first side 22a toward the second side 22b (without reaching the second side 22b), with a depth along the Z axis of approximately 4-5 µm measured from the top side 22a. The trench 23 is symmetric with respect to the axis of symmetry H. According to one embodiment, the trench 23 is formed by means of photolithography and etching steps, which are in themselves known. For example, anisotropic etching (such as DRIE or RIE type) is used.

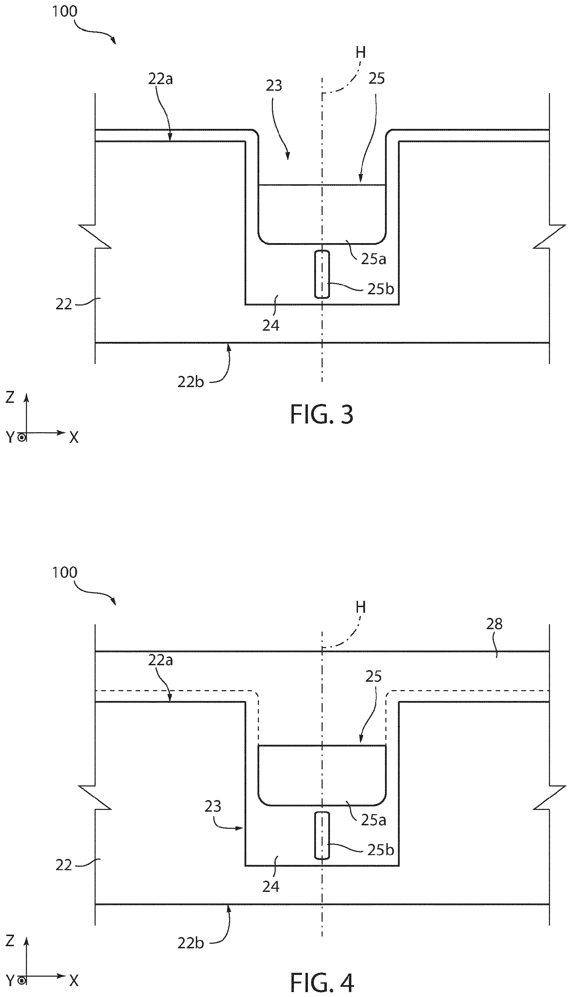

Then, Figure 3, the trench 23 is partially filled with a field plate oxide layer 24, for example of Silicon Oxide, and with a gate oxide layer 26 over the field plate oxide layer 24. The field plate oxide layer 24 and the gate oxide layer 26 can be deposited or thermally grown. A conductive gate layer 25a, such as N-doped polysilicon, is further formed (e.g., deposited) in the trench 23 on the field plate oxide layer 24 and the gate oxide layer 26.

In one embodiment, the lower portions of the trench 23 (including its sidewalls and bottom wall) are completely covered by the field plate oxide layer 24. A buried field plate poly 25b can also be formed in the trench 23, below the conductive gate layer 25a, in a per se known way, and is used to reduce the electric field in the semiconductor body 22 near the trench 23 and to lower parasitic capacitance. The field plate 25b is buried within the field plate oxide layer 24. The field plate 25b is electrically isolated from the conductive layer 25a. This structure is also known as "shielded-gate" or "split-gate". In the following, the conductive gate layer 25a is also named upper gate portion 25a (it is the actual transistor's gate electrode). The field plate 25b may be grounded.

It is noted that the upper gate portion 25a is recessed with respect to the first side 22a of a depth of about 200 nm measured from the first side 22a along the Z axis. This may be achieved by carrying out an etching step of the polysilicon after deposition, until the desired thickness of the upper gate portion 25a is achieved.

Then, Figure 4, a step of growing or depositing an oxide layer 28 on the wafer, in particular on the gate oxide layer 26 and on the upper gate portion 25a, is carried out. For example, a LPCVD step is performed to deposit Silicon Oxide, forming the oxide layer 28. The layers 26 and 28 (here, of the same material SiO₂) have a total thickness of about 500 nm measured from the first side 22a along the Z axis.

A CMP step is then carried out, to planarize the surface of the oxide layer 28 and to reduce its thickness down to about 300nm.

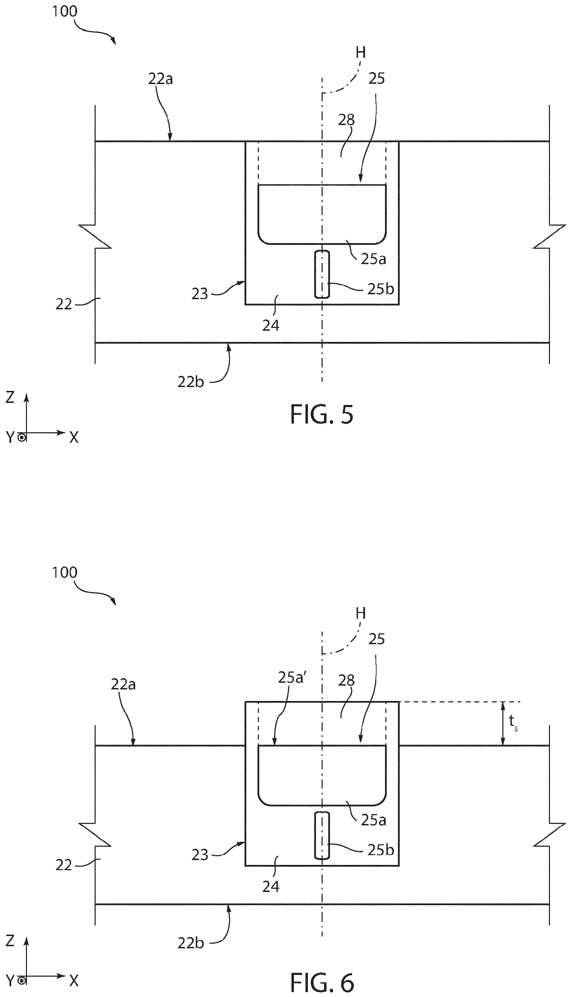

With reference to Figure 5, a further etching step (in particular, an unmasked anisotropic etching) is carried out to remove the oxide layers 26 and 28 from the first side 22a of the semiconductor body 22, leaving portions of the oxide layers 26 and 28 extending within the trench 23. Therefore, the oxide layer 28 now extends within the trench 23 on the upper gate portion 25a, and has a top surface that is substantially coplanar with the first side 22a.

Then, Figure 6, the semiconductor body 22 is etched laterally to the trench 23, at both sides of the trench 23, reducing the thickness of the semiconductor body 22 of about t_{S}=180 nm along the Z axis. The first side 22a of the substrate, after this etching step, extends approximately at the same level, along the Z axis, as the top side 25a' of the upper gate portion 25a. As a consequence of the etching of the semiconductor body 22, the gate oxide layer 26 and the oxide layer 28 protrude from the first side 22a of the semiconductor body 22.

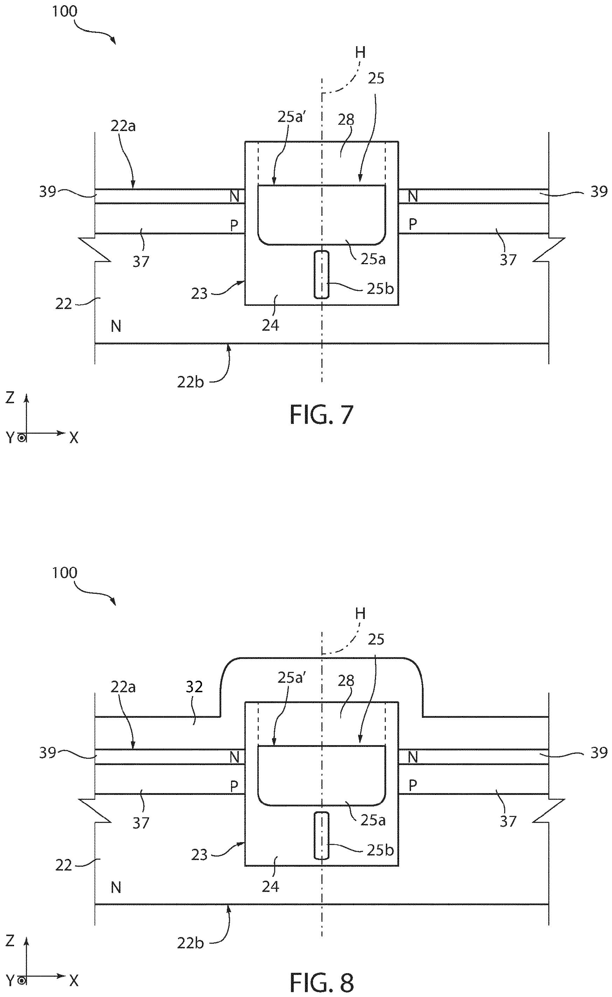

Then, Figure 7, there follows a step of forming a body region 37 of the MOS device. This step includes an unmasked implant of doping species having a second type of conductivity different from the first type of conductivity (here, a P-type), for example Boron. In this way an implanted region which extends along and below the first side 22a of the semiconductor body 22, lateral and adjacent to the trench 23, is formed. The implant is for example performed using an implanting energy of 80 keV, achieving a concentration of doping species of approximately 1·10¹⁸ atoms/cm³. A step of heat treatment at a temperature of approximately 1000 °C for approximately 30 seconds is carried out, in order to allow activation of the implanted species, forming the body region 37. For example, the body region 37 reaches a depth of approximately 0.5 µm along Z from the first side 22a of the semiconductor body 22. The region of the semiconductor body 22 proximate to the second side 22b, which is not reached by the diffusion of the doping species and is therefore outside the body region 37, forms a drain region of the semiconductor body 22.

Then, a step of forming a source region 39 of the MOS transistor is carried out. For this purpose doping species having the first type of conductivity (N-type), for example Arsenic, are implanted at the first side 22a of the semiconductor body 22, within the body region 37. Implantation is carried out using an implantation energy of for example 30 keV, achieving a concentration of doping species of the order of 1·10²⁰ atoms/cm³. A step of heat treatment at a temperature of approximately 1000 °C for approximately 30 seconds is carried out, to activate the implanted species, forming the source region 39. The source region 39 extends along the direction of the Z axis to a depth smaller than that of the body region 37. For example, the source region 39 reaches a depth of approximately less than 0.1 µm from the first side 22a of the semiconductor body 22.

Then, Figure 8, a spacer layer 32, for example of oxide, such as Silicon Oxide, is formed on the wafer, covering the first side 22a of the semiconductor body 22, the gate oxide layer 26 and the oxide layer 28.

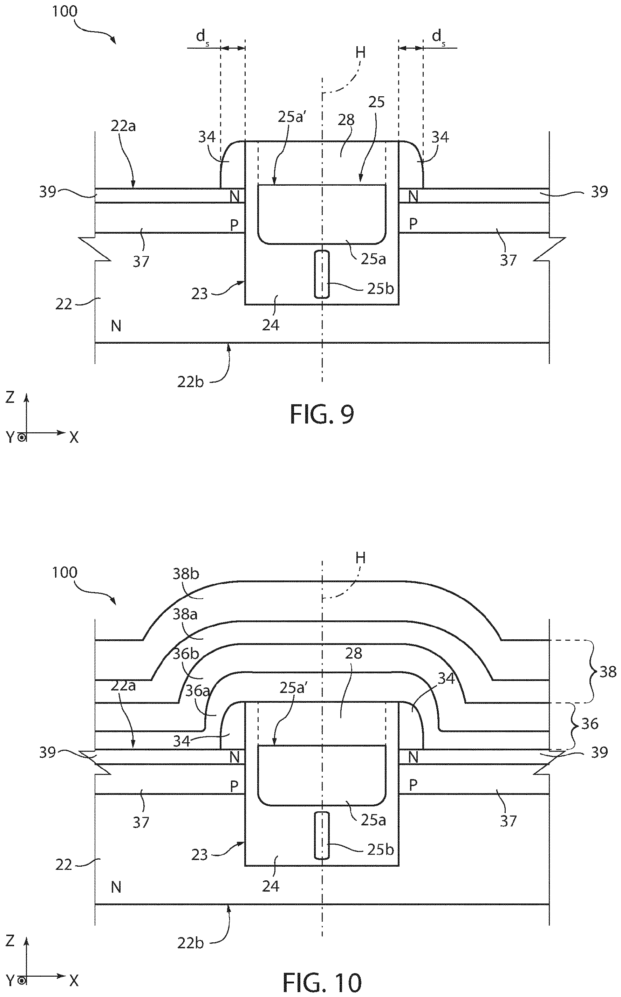

An etching step is carried out, Figure 9, to partially remove the spacer layer 32. The etching is, in this case, an unmasked etching, in particular an anisotropic dry etching directed along the Z axis, configured to remove the spacer layer 32 on the horizontal (XY) plane, while preserving the spacer layer 32 on the vertical (XZ, YZ) planes. The etching is stopped when the spacer layer 32 is removed for its entire thickness on the first side 22a, with the exception of portions of the spacer layer 32 extending vertically (along the Z direction) along the lateral (vertical) sides of the gate oxide layer 26. Therefore, the spacers 34 are formed on the semiconductor body 22 next to, and adjacent to, the lateral sides of the gate oxide layer 26 previously formed in the trench 23 and protruding from the first side 22a of the semiconductor body 22. Each spacer 34 covers a portion of the first side 22a that is adjacent to the gate oxide layer 24. The spacers 34 thus formed are symmetrical with respect to symmetry axis H, have the same shape and also have a same base area (in other words, they cover a same respective area or same respective amount of semiconductor body 22 at the first side 22a).

The maximum extension d_{S} (along the X axis) of each spacer 34 is at the interface with the first side 22a; d_{S} measures at least 0.15 nm from the respective lateral side of the trench 23/gate oxide layer 24 to which each spacer 34 is adjacent.

Then, Figure 10, a double layer 36 of insulating or dielectric material is formed by depositing a first sub-layer 36a of oxide (e.g., Silicon Oxide) with a thickness of about 20 nm, and a second sub-layer 36b of nitride (e.g., Silicon Nitride) over the first sub-layer 36a, with a thickness of about 30 nm. Deposition of the sub-layers 36a and 36b is carried out for example by LPCVD technique.

Then, a further deposition step is carried out to form a further bilayer 38 comprising a first sub-layer 38a of insulating material, such as silicon oxide, over the second sub-layer 36b, and having a thickness of about 200 nm, and a second sub-layer 38b over the first sub-layer 38a. The second sub-layer 38b is a pre-metal dielectric (PMD), for example of of Borophosphosilicate glass (BPSG). The second sub-layer 38b has a thickness between 500 and 700 nm, in particular between 550 and 650 nm, more in particular of about 650 nm. The sub-layer 38b may be formed by subatmospheric CVD (SACVD).

The double layer 36 acts as a protection layer during the subsequent steps of forming and patterning the further bilayer 38.

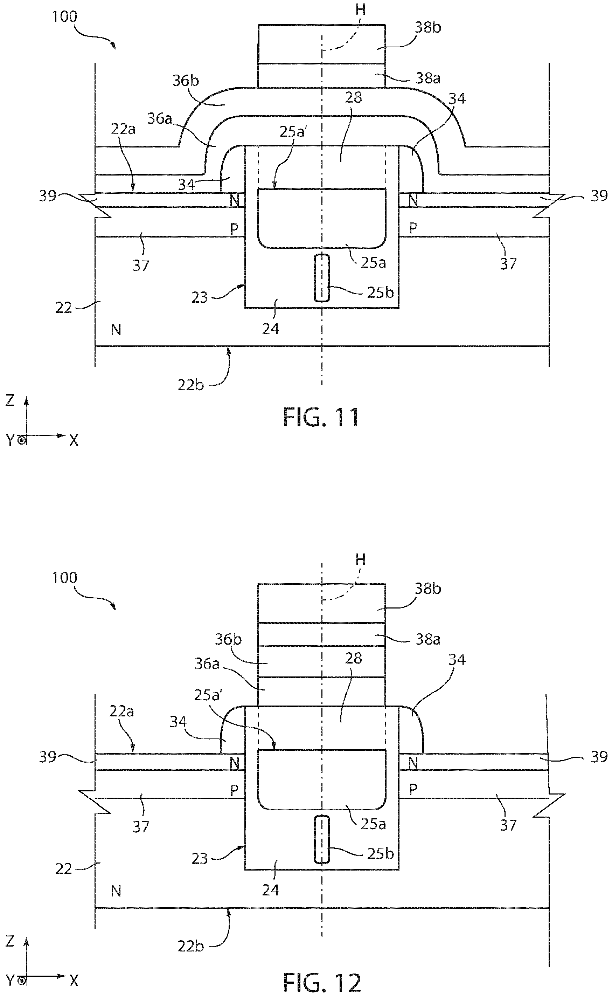

Then, Figure 11, the bilayer 38 is patterned in order to maintain the bilayer 38 on the upper gate portion 25a (substantially aligned, along the Z axis, with the upper gate portion 25a), and to remove the bilayer 38 from the remaining portions of the wafer. After patterning, the bilayer 38 does not cover the spacers 34, and therefore, in top plan view (i.e., view on the XY plane), it is contained between the spacers 34. To do so, a masked etching (or a photolithographic process) is performed, selectively removing portions of the bilayer 38 extending lateral to the gate portion 25a. The bilayer 38 is etched for its entire thickness where it has to be removed, using the second sub-layer 36b as an etching-stop layer. Accordingly, the chemical etchant is properly chosen to achieve such selectivity.

Then, Figure 12, the second sub-layer 36b is removed from the wafer, with the exception of the portions of the second sub-layer 36b covered by the bilayer 38 (on the gate region, where the bilayer 38 is still present). According to a non-claimed embodiment, portions of the second sub-layer 36b may still cover in part the spacers 34, depending on the etching technique used (in particular, when the etching has a high directivity along the Z axis, portions of the second sub-layer 36b may remain along the vertical sides of the spacers 34).

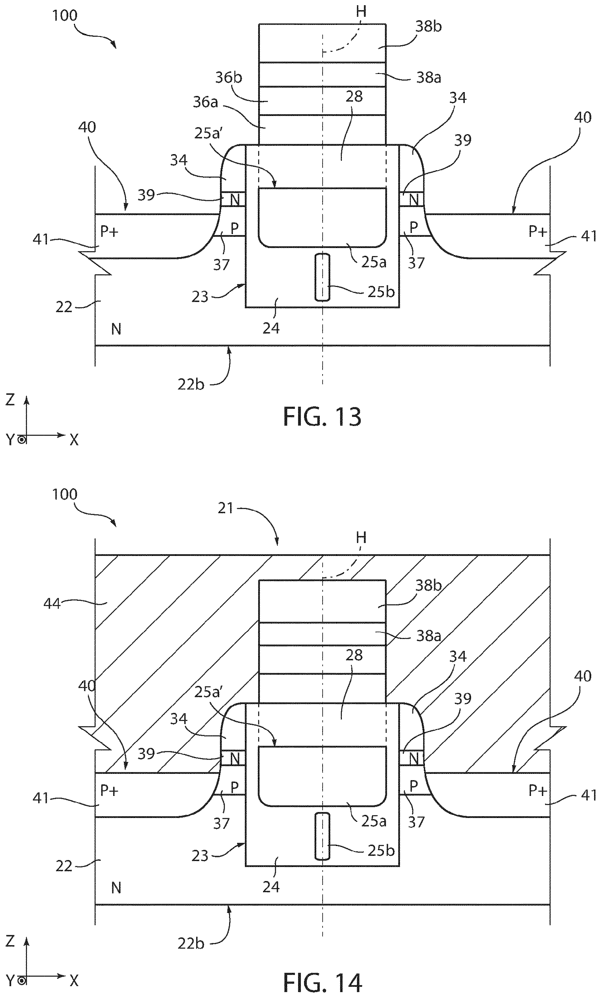

Then, Figure 13, micro-trenches or recesses 40 are opened in the semiconductor body 22, lateral to the trench-gate 23 and lateral to the spacers 34. The spacers 34 act as an etching mask, so that during this etching step portions of the semiconductor body 22 not covered by the spacers 34 are selectively removed to form the trenches 40. Due to the symmetry of the spacers with respect to the axis H, also the recesses 40 are symmetric with respect to the axis H, and are auto-aligned. It is noted that, since the MOS transistor under manufacturing includes a plurality of cells 100 one next to the other, each recess 40 extends between, and is auto aligned to, two spacers 34. No photolithographic masks and related processes are therefore required.

The recesses 40 extend vertically from the first side 22a of the semiconductor body 22 through part of the semiconductor body 22, toward the second side 22b. The recesses 40 extend along the direction of the Z axis for a depth of approximately 300 nm. Each recess 40 is designed to extend over the entire thickness of the source region 39 and through part of the body region 37 of the device under fabrication, without reaching the drain region of the semiconductor body 22. The recess 40 is formed by anisotropic dry etching, thereby etching the Silicon material of the semiconductor body 22 selectively with respect to the material of the bilayer 38 (in particular sub-layer 38b) and the Silicon Oxide of the spacers 34. Because the spacers 34 are symmetrical with respect to the axis of symmetry H by design and the process described so far, not only the recesses 40 are also symmetrical with respect to the axis of symmetry H, but also the source 39 and body regions 37..

Then, a step of forming enriched body regions 41 of the MOS transistor is carried out. For this purpose, doping species having the same type of conductivity as the body regions 39 (here, a P-type conductivity, for example Boron) are implanted. The implantation dose is higher than that of the body regions 39. The spacers 34 act as an implant mask which is auto-aligned with respect to the axis of symmetry H, such that the doping species penetrate in the region of the semiconductor body below the bottom wall of the recesses 40 (direction of implantation is along the Z axis). Implanting is for example carried out with an implanting energy of 40 keV, achieving a concentration of dopant species of approximately 8·10¹⁸ atoms/cm³. Then, a step of heat treatment is performed, for example at a temperature of 1000 °C for a time of 30 seconds, sufficient to cause the activation of the implanted species. The enriched body regions 41 thus formed extend below each recess 40; in one embodiment the enriched body regions 41 extend as far as a depth equal to or greater than that of the respective body region (without however reaching the second side 22b of the semiconductor body 22). In a different embodiment, the enriched body regions 41 are completely contained within the respective body region 37 and extend as far as a depth lower than that of the respective body region 37.

Then, Figure 14, a conductive terminal 44 is formed by depositing a metal material such as aluminium, tungsten and its barrier of titanium and titanium nitride on the wafer. The conductive terminal 44 completely fills the recesses 40 and is therefore in electrical contact with the semiconductor body 22 and with the source regions 39, the enriched body regions 41 and the body regions 37 through the enriched body regions 41. The conductive terminal 44 forms a source electrode of the MOS transistor 21.

Thanks to the symmetry of the recesses 40, the enriched body regions 41 are symmetrical with respect to the axis of symmetry H and auto-aligned with respect to the trench gate and the regions where, during use, conductive channels will form.

In particular the distances along the X axis between the trench-gate 23 and the enriched body regions 41are the same at both lateral sides of the trench-gate 23. In other words, the extension of the channel regions (as well as that of the source regions) is uniform in the entire cell 100 and symmetrical with respect to the axis of symmetry H.

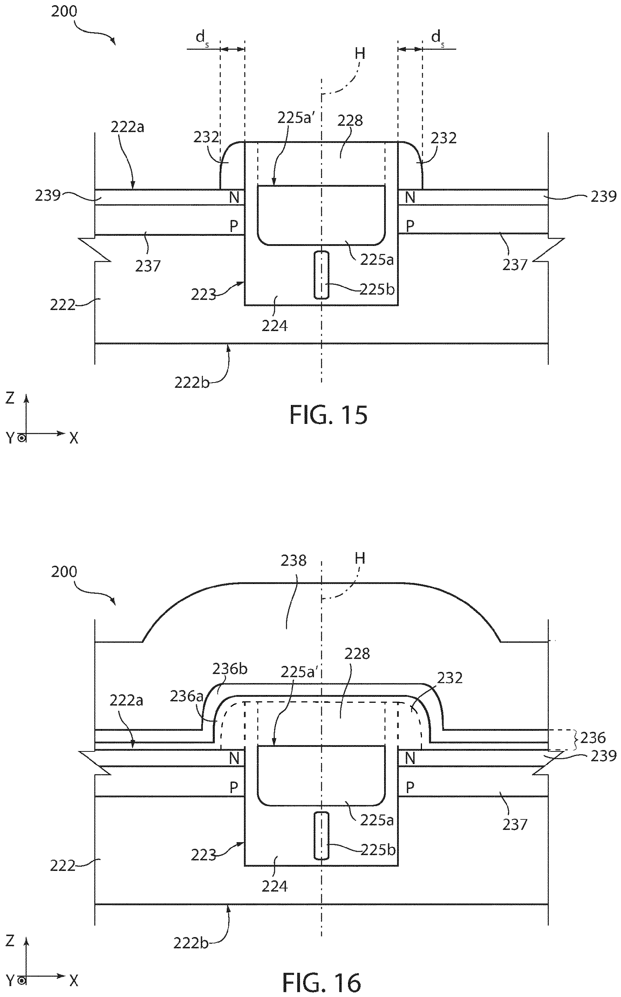

Figures 15-19 illustrate another embodiment of manufacturing a MOS transistor. A semiconductor body 222 may be of silicon and have a first type of conductivity. A first side 222a of the semiconductor body 222 is etched to have a trench 223. The semiconductor body 222 has a second side 222b, opposite the first side 222a, that is substantially parallel to the X axis.

A field plate insulating layer 224, an upper gate portion 225a, a buried field plate poly 225b, and an insulating layer 228 are formed in the trench 223 in a similar manner as described above with respect to other embodiments. The upper gate portion 225a has a top side 225a'. The field plate insulating layer 224 and the insulating layer 228 may be of silicon dioxide. The upper gate portion 225a and buried field plate poly 225b may be of polysilicon.

A body region 237 having a second type of conductivity different from the first type of conductivity, for example, a P-type as shown in Figure 15, is formed in the semiconductor body 222. The body region 237 is spaced more from the second side 222b of the semiconductor body 222 than the first side 222a of the semiconductor body 222. The body region 237 is aligned with the upper gate portion in along the X direction.

A source region 239 having the first type of conductivity, for example, N-type as shown in Figure 15, is formed at the first side 222a of the semiconductor body 222 and within the body region 237. The body region 237 has a thickness in the Z direction greater than a thickness in the Z direction of the source region 239. The source region 239 and the body region 237 extend in the X direction to lateral walls of the trench 223. The body region 237 and source region 239 are formed in similar manners as described above with respect to other embodiments.

In Figure 15, an insulating spacer layer 232 is deposited, for example via LPCVD, at lateral sides of the field plate insulating layer 224 and etched. The spacer layer 232 is formed adjacent to sidewalls of the insulating layer 228 that extend away from the surface 222a. The spacer layer 232 is also on the surface 222a. The spacer layer 232 has a dimension ds from the sidewalls of the insulating layer 228 to an outermost surface of the spacer layer 232. The spacer layer 232 may also be silicon dioxide.

In Figure 16, a first insulating layer 236a, which may be of silicon dioxide is deposited, for example via LPCVD, on the first side 222a of the semiconductor body, the spacer layer 232, the field plate layer 224, and the insulating layer 228. Then, a nitride layer 236b, that may be of silicon nitride, is deposited, for example via LPCVD, on the silicon dioxide layer 236a. The nitride layer 236b has a thickness in the Z direction greater than a thickness in the Z direction of the silicon dioxide layer 236a. The boundaries of the spacer layer 232 and the first insulating layer are shown in dash as they are the same material in some embodiments. Layers 236a and 236b form together a double layer (or bilayer) 236 having a protective function.

A second insulating layer 238 is deposited, for example via a sub-atmospheric chemical vapor deposition (SACVD), over the nitride layer 236b. The second insulating layer 238 has a thickness that is greater than a sum of the thickness of the first insulating layer 236a and the nitride layer 236b along the Z direction.

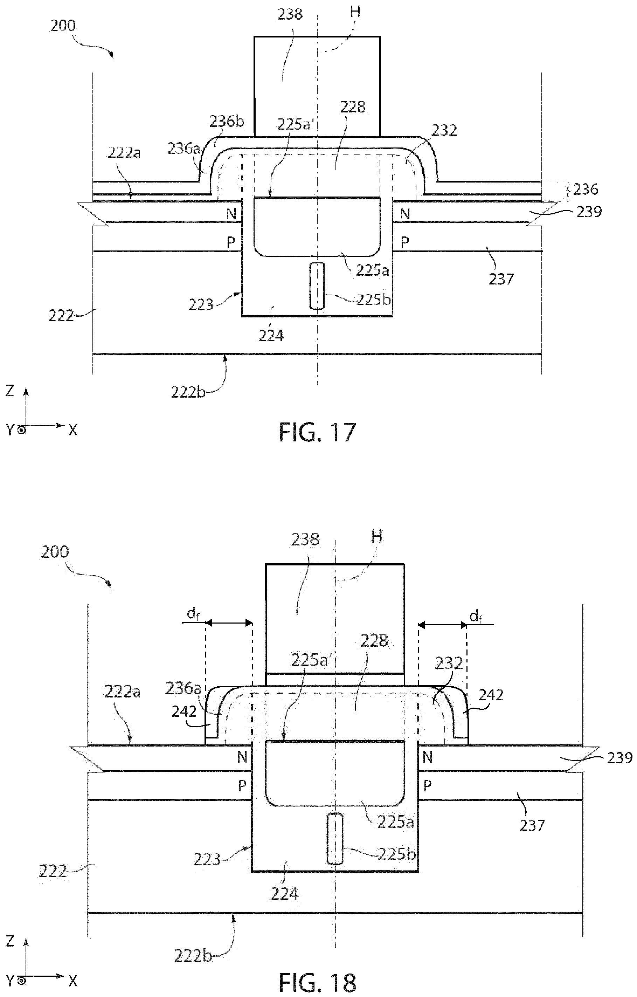

Then, in Figure 17, the second oxide layer 238 is etched, for example using a contact mask, which is removed, for example via resist removal, after etching is complete. The resulting etched second oxide layer 238 is over the oxide insulating layer 228 and is no longer over the field plate oxide layer 224 or the oxide spacer layer 232. It is noted that the second oxide layer 238 may be formed in a single process or may be formed in two steps, such as an SACVD step followed by a borophosphosilicate glass (BPSG) step. The SACVD step may form a 2,000 angstrom layer. The BPSG step may form a 6,500 angstrom layer.

Next, the nitride layer 236b and the first insulating layer 236a are etched in Figure 18. The nitride layer 236b is etched to form a spacer nitride 242. Portions of the first surface 222a of the semiconductor body 222 and the first insulating layer 236a are exposed. A combined spacer includes spacer layer 232 and spacer nitride 242. The combined spacer extends from the side wall of the insulating layer 228 to an outer edge of the spacer nitride 242. The combined spacer has a final dimension df. This dimension df is greater than the dimension ds.

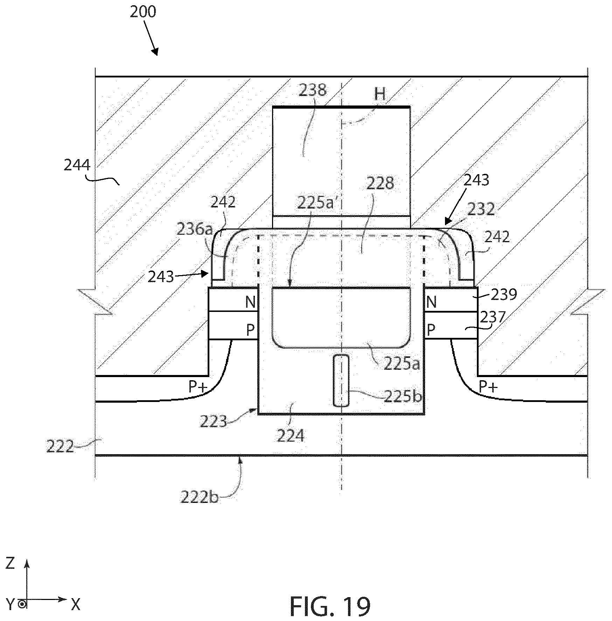

A trench is etched in the semiconductor body 222 in Figure 19 and a front metal 244 is deposited. The trench extends into the semiconductor body 222 to an intermediate location between the first surface 222a and a bottom surface or area of the field plate layer 224. A channel region is formed in the portion of the semiconductor body 222 that is under the combined sidewall and adjacent to the field plate layer 224. The spacer nitride 242 controls a dimension of the combined spacer to manage and control a dimension in the X direction of the channel formed in the semiconductor body.

A P+ region may be formed in the remaining semiconductor body 222 with a variety of techniques. The P+ region extends from the body region 237 in the portion of the semiconductor body that is adjacent to the field plate layer 224.

The advantages of the present invention are discussed below.

In the process of manufacturing the MOS transistor the formation of spacers 34, which are symmetrical with respect to the axis of symmetry H, makes it possible to form source, body and body-enriched regions that are auto-aligned with the gate electrode, overcoming the limitations of MOS transistors of the known type in which such regions are formed by means of photolithographic techniques (with a consequent risk of asymmetry).

Furthermore, the auto-alignment of the above-mentioned regions makes it possible to reduce the electrical resistance of the portion of the body region through which the turn-off current passes under unclamped inductive switching (UIS) conditions.

It is thus possible to maximize the capacity of the MOS transistor to control high currents under unclamped inductive switching conditions.

Further to the above, the present invention allows the use of a pre-metal dielectric (layer 38b) as thick as needed (i.e. for sustaining high voltages), still maintaining a contact opening well controlled in terms of distance and alignment. This is obtained not only through the formation of thin spacers 34, which ensure a tight process control on silicon contact, but also by the introduction of layers 36a and 36b. The latter act as a whole as a protection layer 36 during the following deposition / masking / etching steps related to the formation of the thick layer 38. The thick layer 38 gives to the whole device structure a high level of electrical insulation (needed for higher voltage device) and high reliability performances (lower average electric field within it). By this way it is possible to use a lithographic mask to open and etch the layer 38 and finally remove the protection layer 36 without impact on silicon contact control/spread and its alignment.

Moreover, the present invention enables logic-level Vth technology using lower body dose without the adverse effect from body enrichment misalignment that impacts the Vth.

Balanced current flow distribution during switch off operation is also achieved. Higher UIS capabilities are therefore achieved.

Wider contacts are allowed due to improved contact alignment (no alignment margin is needed).

Finally, the present invention enables a pitch reduction for better on-state resistance contributed by Silicon and normalized by area (Rsil).

Finally it is clear that modifications and variants may be made to the invention described and illustrated here without thereby going beyond the protective scope of the present invention as defined in the appended claims.

For example, the trench 23 has been described having vertical sidewalls; according to the process used for manufacturing the trench 23, it may also have inclined sidewalls, in particular sidewalls forming, in the cross-section view of figures 1-14, an obtuse angle (>90°) at the intersection with the front side 22a (in this case, the trench 23 has a truncated V-like shape in a side view, or a truncated reversed-pyramid shape). The teaching of the present invention applies analogously also in case of sidewalls of the trench 23 not perfectly parallel to the Z axis.

In particular, the present invention can be applied to any type of vertically-conducting device with a trench gate, such as a VDMOS transistor, or a trench-based power MOSFET device.

## Claims

1. A method for manufacturing a MOS transistor (21), comprising the steps of:
forming a trench (23) at a first side (22a) of a semiconductor body (22) of semiconductor material, the trench (23) having a first and a second side opposite to one another and extending towards a second side (22b) of the semiconductor body (22);
filling the trench (23) by forming, within the trench (23), a first oxide region (24, 26), a conductive gate region (25a) that is electrically isolated from the semiconductor body (22) by said first oxide region (24, 26), and a second oxide region (28) on the conductive gate region (25a), the second oxide region (28) being physically separated from the semiconductor body (22) by said first oxide region (24, 26);
removing portions of the semiconductor body adjacent to the first and second sides of the trench;
forming a first and a second body region (37) having a second type of conductivity (P), the first and second body regions (37) being adjacent to the respective first and second sides of the trench (23);
forming a first and a second source region (39) having a first type of conductivity (N) in the respective first and second body region (37), the first type of conductivity being different from the second type of conductivity;
forming first and second spacers (34) adjacent to the first and second oxide regions and on the first and the second source region;
forming, in the semiconductor body (22), a first recess (40) extending through said first source region (39) and said first body region (37) using said first spacer (34) as an etching mask;
forming, in the semiconductor body (22), a second recess (40) extending through said second source region (39) and said second body region (37) using said second spacer (34) as an etching mask; and
forming first and second enriched regions in electrical contact with the respective first and second body regions, including implanting dopant species of the second type of conductivity (P) in the first and the second recess (40) using said first and second spacers (34) as implant masks,
**characterized by** comprising, before the steps of forming the first and second recess (40), the further steps of:
forming a first sub-layer (36a; 236a), of a first dielectric material, on the second oxide region (28), on the first and second spacers (34) and on the first and second source regions (39);
forming a second sub-layer (36b; 236b), of a second dielectric material different from the first dielectric material, on the first sub-layer (36a; 236a);
forming a third sub-layer (38b; 238), of a third dielectric material different from the first and second dielectric materials, on the second sub-layer (36b; 236b);
patterning the third sub-layer (38b; 238) to form a third sub-region above the second oxide region (28);
patterning the first and the second sub-layer (36a, 36b; 236a, 236b) using the third sub-region as patterning mask, to form respective first and second sub-regions between the second oxide region (28) and the third sub-region; and
forming a metal contact layer (44) in the first and second recesses (40) to electrically contact the first and second source regions (39), and on the first, second and third sub-regions.

2. The method of claim 1, wherein the first dielectric material is an oxide of said semiconductor material, and the second dielectric material is a nitride of said semiconductor material.

3. The method of claim 1 or claim 2, wherein the third sub-layer is a pre-metal dielectric, PMD.

4. The method of anyone of claims 1-3, wherein the third dielectric material is borophosphosilicate glass, BPSG.

5. The method of anyone of claims 1-4, further comprising the steps of:
before forming the third sub-layer (38b), forming a fourth sub-layer (38a), of a fourth dielectric material different from the second dielectric material, on the second sub-layer (36b); and
patterning the fourth sub-layer to form a fourth sub-region between the second oxide region (28) and the third sub-region (38b),
wherein the fourth dielectric material is an oxide of said semiconductor material.

6. The method of anyone of claim 5, wherein the steps of patterning the third and fourth sub-layers (38a, 38b) include performing a masked etching to selectively remove portions of the third and fourth sub-layers (38a, 38b) extending lateral to the second oxide region (28).

7. The method of claim 6, wherein patterning the third and the fourth sub-layer (38a, 38b) further includes etching patterning the third and fourth sub-layers (38a, 38b) for their entire thickness laterally to the second oxide region (28), the second sub-layer (36b) being an etching-stop layer.

8. The method of anyone of claims 1-4, wherein the steps of patterning the third sub-layer (238) includes performing a masked etching to selectively remove portions of the third sub-layer extending lateral to the first and second spacers (232);
the method further comprising the steps of:
selectively removing portions of the first and of the second sub-layer (236a, 236b) extending lateral to the first and second spacers (232); and
maintaining portions of the first and of the second sub-layer (236a, 236b) covering the first and of the second spacer (232).

9. The method of anyone of the preceding claims, wherein the first and the second side of the trench (23) extending symmetric to one another with respect to an axis of symmetry (H) orthogonal to the first and second side (22a, 22b).

10. The method of claim 9, further comprising:
forming a drain electrode at the second side (22b) of the semiconductor body (22);
after filling the trench (23) and before forming the first and second body regions (37) and the first and second source regions (39), reducing a thickness of the semiconductor body (22) by removing, at the first side (22a), portions of the semiconductor body (22) adjacent to the first and the second side of the trench (23), so that the first oxide region (24, 26) and of the second oxide region (28) protrude in part from the semiconductor body (22) at the first side (22a);
after forming the first and second body regions (37) and the first and second source regions (39), forming said first and a second spacer (34) adjacent to the oxide region (24, 26)and protruding from the semiconductor body (22) at the first side (22a), the first and second spacers (34) being specular to one another with respect to said axis of symmetry (H) .

11. The method of anyone of the preceding claims, wherein the step of forming the first and second spacers (34) includes the steps of:
forming a spacer layer (32) of insulating or dielectric material on the first side (22a), on the oxide region (24, 26) protruding from the semiconductor body (22) and on the top oxide region (28); and
performing an unmasked etching step to remove portions of the spacer layer (32) extending parallel to the first side (22a).

12. The method of claim 11, wherein the unmasked etching step includes performing an anisotropic dry etching step configured to remove portions of the spacer layer (32) extending parallel to the first side (22a) and to preserve further portions of the spacer layer (32) extending along the first oxide region (24, 26) orthogonal to the first side (22a) .

13. The method of claim 11 or claim 12, wherein the unmasked etching step is stopped when the spacer layer (32) extending parallel to the first side (22a) is completely removed.

14. The method of anyone of the preceding claims, wherein the step of filling the trench (23) includes the further step of forming, within the trench (23) and before forming the conductive gate region (25a), a field plate (25b) of electrically conductive material that is electrically isolated from the semiconductor body (22) by said first oxide region (24, 26).

15. The method of anyone of the preceding claims, wherein the first and second spacers (34) cover a same respective amount of surface region of the first side (22a).

16. A metal oxide semiconductor, MOS, transistor (21), comprising:
a semiconductor body (22) having a first and a second side (22a, 22b) opposite to one another and a first type of conductivity (N);
a trench (23) in the semiconductor body (22) at the first side (22a), the trench (23) having a first and a second side opposite to one another, the first and second sides of the trench being transverse to the first side of the semiconductor body and extending toward the second side of the semiconductor body along a direction (Z);
a first oxide region (24, 26) in the trench on the first and second sides of the trench (23);
a conductive gate region (25a) in said trench (23) on the first oxide region (24, 26), the conductive gate region being electrically isolated from the semiconductor body (22) by said first oxide region (24, 26);
a second oxide region (28) in the trench (23) on the conductive gate region (25a);
a first and a second body region (37) having a second type of conductivity (P) facing the first side (22a) of the semiconductor body (22) and adjacent to the respective first and second lateral sides of the trench (23), the first type of conductivity being different from the second type of conductivity;
a first and a second source region (39) having the first type of conductivity (N) within the respective first and second body region (37) and facing the first side (22a); and
a drain electrode at the second side (22b),
wherein portions of the first and second oxide regions (24, 26, 28) and of the top oxide region (28) protrude in part from the semiconductor body (22) at the first side (22a),
the MOS transistor further comprising:
first and second spacers (34) adjacent to the portions of the first oxide region (24, 26) protruding from the first side of the semiconductor body (22), the portions of the first oxide region (26) being disposed between the second oxide region (28) and the first and second spacers (34) respectively ;
a first recess (40) in the semiconductor body (22), extending through said first source region (39) and said first body region (37) adjacent to said first spacer (34);
a second recess (40) in the semiconductor body (22) extending through said second source region (39) and said second body region (37) adjacent to said second spacer (34);
a first and a second enriched region (41), of the second type of conductivity (P) with a different doping concentration than the first and second body regions, the first and second enriched region being in the respective first and second recess (40), the first and second enriched region being in electrical contact with the first and respectively second body regions (37),
**characterized by** further comprising:
a first sub-layer (36a), of a first dielectric material, on and aligned to the second oxide region (28) along said direction (Z);
a second sub-layer (36b), of a second dielectric material different from the first dielectric material, on and aligned to the first sub-layer (36a) along said direction (Z);
a third sub-layer (38b), of a third dielectric material different from the first and the second dielectric material, on and aligned to the second sub-layer (36b) along said direction (Z); and
a metal contact layer (44) in the first and second recesses (40) in electrical contact with the first and the second source region (39) and on the first, second and third sub-layers (36a, 36b, 38b),wherein the first, second and third sub-layers (36a, 36b, 38b) are aligned to said first and second sides of the trench (23) and to the conductive gate region (25a) along said direction (Z).

17. The MOS transistor of claim 16, further comprising a fourth sub-layer (38b), of a fourth dielectric material different from the second dielectric material, extending between the second and the third sub-layer,
the fourth sub-layer (38b) being aligned to the third sub-layer (38a) along said direction (Z).

18. The MOS transistor of claim 16 or 17, wherein the first dielectric material is an oxide of said semiconductor material, and the second dielectric material is a nitride of said semiconductor material.

19. The MOS transistor of anyone of claims 16-18, wherein the third sub-layer is a pre-metal dielectric, PMD.

20. The MOS transistor of anyone of claims 16-19, wherein the third dielectric material is borophosphosilicate glass, BPSG.

21. The MOS transistor of claim 17, or anyone of claims 18-20 when depending upon claim 17, wherein the fourth dielectric material is an oxide of said semiconductor material.

22. The MOS transistor of anyone of claims 16-21, wherein the first and the second side of the trench (23) extend symmetric to one another with respect to an axis of symmetry (H) orthogonal to the first and second side (22a, 22b).

## Patentansprüche

1. Verfahren zur Herstellung eines MOS-Transistors (21), das die folgenden Schritte umfasst:
Bilden eines Grabens (23) an einer ersten Seite (22a) eines Halbleiterkörpers (22) aus Halbleitermaterial, wobei der Graben (23) eine erste und eine zweite Seite aufweist, die sich gegenüberliegen, und sich in Richtung einer zweiten Seite (22b) des Halbleiterkörpers (22) erstreckt;
Füllen des Grabens (23), indem innerhalb des Grabens (23) ein erster Oxidbereich (24, 26), ein leitfähige Gate-Bereich (25a), der vom Halbleiterkörper (22) durch den ersten Oxidbereich (24, 26) elektrisch isoliert ist, und ein zweiter Oxidbereich (28) auf dem leitfähigen Gate-Bereich (25a) gebildet wird, wobei der zweite Oxidbereich (28) durch den ersten Oxidbereich (24) physisch vom Halbleiterkörper (22, 26) physisch getrennt ist;
Entfernen von Abschnitten des Halbleiterkörpers, die an die erste und die zweite Seite des Grabens angrenzen;
Bilden eines ersten und eines zweiten Körperbereichs (37) mit einem zweiten Leitfähigkeitstyp (P), wobei der erste und der zweite Körperbereich (37) an die jeweilige erste und zweite Seite des Grabens (23) angrenzen;
Bilden eines ersten und eines zweiten Source-Bereichs (39) mit
einem ersten Leitfähigkeitstyp (N) in dem jeweiligen ersten und zweiten Körperbereich (37), wobei sich der erste Leitfähigkeitstyp vom zweiten Leitfähigkeitstyp unterscheidet; Bilden eines ersten und eines zweiten Abstandshalters (34), die an den ersten und den zweiten Oxidbereich und auf dem ersten und dem zweiten Source-Bereich angrenzen;
Bilden einer ersten Vertiefung (40), die sich durch den ersten Source-Bereich (39) und den ersten Körperbereich (37) erstreckt, in dem Halbleiterkörper (22) unter Verwendung des ersten Abstandshalters (34) als Ätzmaske;
Bilden einer zweiten Vertiefung (40), die sich durch den zweiten Source-Bereich (39) und den zweiten Körperbereich (37) erstreckt, in dem Halbleiterkörper (22) unter Verwendung des zweiten Abstandshalters (34) als Ätzmaske; und
Bilden von ersten und zweiten angereicherten Regionen in elektrischem Kontakt mit den jeweiligen ersten und zweiten Körperbereich, einschließlich des Implantierens von Dotierstoffspezies des zweiten Leitfähigkeitstyps (P) in die erste und die zweite Vertiefung (40) unter Verwendung der ersten und zweiten Abstandhalter (34) als Implantatmasken, **dadurch gekennzeichnet, dass** es vor den Schritten des Bildens der ersten und der zweiten Vertiefung (40) die folgenden weiteren Schritte umfasst:
Bilden einer ersten Unterschicht (36a; 236a) aus einem ersten dielektrischen Material auf dem zweiten Oxidbereich (28), auf dem ersten und dem zweiten Abstandshalter (34) und auf dem ersten und dem zweiten Source-Bereich (39);
Bilden einer zweiten Unterschicht (36b; 236b) aus einem zweiten dielektrischen Material, das sich vom ersten dielektrischen Material unterscheidet, auf der ersten Unterschicht (36a; 236a);
Bilden einer dritten Unterschicht (38b; 238) aus einem dritten dielektrischen Material, das sich von dem ersten und dem zweiten dielektrischen Material unterscheidet, auf der zweiten Unterschicht (36b; 236b);
Strukturieren der dritten Unterschicht (38b; 238), um einen dritten Unterbereich oberhalb des zweiten Oxidbereichs (28) zu bilden;
Strukturieren der ersten und der zweiten Unterschicht (36a, 36b; 236a, 236b) unter Verwendung des dritten Unterbereichs als Strukturmaske, um jeweils erste und zweite Unterbereiche zwischen dem zweiten Oxidbereich (28) und dem dritten Unterbereich zu bilden; und
Bilden einer Metallkontaktschicht (44) in der ersten und der zweiten Vertiefung (40), um den ersten und den zweiten Source-Bereich (39) elektrisch zu kontaktieren, sowie auf dem ersten, dem zweiten und dem dritten Unterbereich.

2. Verfahren nach Anspruch 1, wobei das erste dielektrische Material ein Oxid des Halbleitermaterials ist und das zweite dielektrische Material ein Nitrid des Halbleitermaterials ist.

3. Verfahren nach Anspruch 1 oder Anspruch 2, wobei die dritte Unterschicht ein Prämetall-Dielektrikum, PMD, ist.

4. Verfahren nach einem der Ansprüche 1-3, wobei das dritte dielektrische Material Borphosphorsilikatglas, BPSG, ist.

5. Verfahren nach einem der Ansprüche 1-4, das ferner die folgenden Schritte umfasst:
vor dem Bilden der dritten Unterschicht (38b), Bilden einer vierten Unterschicht (38a) aus einem vierten dielektrischen Material, das sich vom zweiten dielektrischen Material unterscheidet, auf der zweiten Unterschicht (36b); und
Strukturieren der vierten Unterschicht, um einen vierten Unterbereich zwischen dem zweiten Oxidbereich (28) und dem dritten Unterbereich (38b) zu bilden,
wobei das vierte dielektrische Material ein Oxid des Halbleitermaterials ist.

6. Verfahren nach Anspruch 5, wobei die Schritte des Strukturierens der dritten und der vierten Unterschicht (38a, 38b) das Durchführen eines maskierten Ätzens enthalten, um Abschnitte der dritten und der vierten Unterschicht (38a, 38b), die sich lateral zum zweiten Oxidbereich (28) erstrecken, selektiv zu entfernen.

7. Verfahren nach Anspruch 6, wobei das Strukturieren der dritten und der vierten Unterschicht (38a, 38b) ferner das Ätzen der Strukturierung der dritten und der vierten Unterschicht (38a, 38b) über ihre gesamte Dicke lateral zum zweiten Oxidbereich (28) enthält, wobei die zweite Unterschicht (36b) eine Ätzstoppschicht ist.

8. Verfahren nach einem der Ansprüche 1-4, wobei die Schritte des Strukturierens der dritten Unterschicht (238) das Durchführen eines maskierten Ätzens enthalten, um Abschnitte der dritten Unterschicht, die sich lateral zu dem ersten und dem zweiten Abstandshalter (232) erstrecken, selektiv zu entfernen;
wobei das Verfahren ferner die folgenden Schritte umfasst:
selektives Entfernen von Abschnitten der ersten und der zweiten Unterschicht (236a, 236b), die sich lateral zu dem ersten und dem zweiten Abstandshalter (232) erstrecken; und
Aufrechterhalten von Abschnitten der ersten und der zweiten Unterschicht (236a, 236b), die den ersten und den zweiten Abstandshalter (232) abdecken.

9. Verfahren nach einem der vorhergehenden Ansprüche, wobei sich die erste und die zweite Seite des Grabens (23) in Bezug auf eine Symmetrieachse (H), die orthogonal zu der ersten und der zweiten Seite (22a, 22b) ist, symmetrisch zueinander erstrecken.

10. Verfahren nach Anspruch 9, das ferner Folgendes umfasst:
Bilden einer Drain-Elektrode an der zweiten Seite (22b) des Halbleiterkörpers (22);
nach dem Füllen des Grabens (23) und vor dem Bilden des ersten und des zweiten Körperbereichs (37) und des ersten und des zweiten Source-Bereichs (39), Reduzieren einer Dicke des Halbleiterkörpers (22), indem an der ersten Seite (22a) Abschnitte des Halbleiterkörpers (22), die an die erste und die zweite Seite des Grabens (23) angrenzen, entfernt werden, so dass der erste Oxidbereich (24, 26) und der zweite Oxidbereich (28) an der ersten Seite (22) teilweise aus dem Halbleiterkörper (22) herausragen;
nach dem Bilden des ersten und des zweiten Körperbereichs (37) und des ersten und des zweiten Source-Bereichs (39), Bilden des ersten und eines zweiten Abstandhalters (34), die an den Oxidbereich (24, 26) angrenzen und an der ersten Seite (22a) aus dem Halbleiterkörper (22) herausragen, wobei der erste und der zweite Abstandhalter (34) in Bezug auf die Symmetrieachse (H) spiegelnd zueinander sind.

11. Verfahren nach einem der vorhergehenden Ansprüche, wobei der Schritt des Bildens des ersten und des zweiten Abstandshalters (34) die folgenden Schritte umfasst:
Bilden einer Abstandsschicht (32) aus isolierendem oder dielektrischem Material auf der ersten Seite (22a) auf dem Oxidbereich (24, 26), der aus dem Halbleiterkörper (22) herausragt, und auf dem oberen Oxidbereich (28); und
Durchführen eines unmaskierten Ätzschritts, um Abschnitte der Abstandsschicht (32), die sich parallel zur ersten Seite (22a) erstrecken, zu entfernen.

12. Verfahren nach Anspruch 11, wobei der unmaskierte Ätzschritt das Durchführen eines anisotropen Trockenätzschritts umfasst, der so eingerichtet ist, dass er Abschnitte der Abstandsschicht (32) entfernt, die sich parallel zur ersten Seite (22a) erstrecken, und weitere Abschnitte der Abstandsschicht (32) konserviert, die sich entlang des ersten Oxidbereichs (24, 26) orthogonal zu der ersten Seite (22a) erstrecken.

13. Verfahren nach Anspruch 11 oder Anspruch 12, wobei der unmaskierte Ätzschritt gestoppt wird, wenn die Abstandsschicht (32), die sich parallel zur ersten Seite (22a) erstreckt, vollständig entfernt ist.

14. Verfahren nach einem der vorhergehenden Ansprüche, wobei der Schritt des Füllens des Grabens (23) den weiteren Schritt des Bildens einer Feldplatte (25b) aus elektrisch leitfähigem Material, die vom Halbleiterkörper (22) durch den ersten Oxidbereich (24, 26) elektrisch isoliert ist, innerhalb des Grabens (23) und vor dem Bilden des leitfähigen Gate-Bereichs (25a) enthält.

15. Verfahren nach einem der vorhergehenden Ansprüche, wobei der erste und der zweite Abstandshalter (34) einen gleichen jeweiligen Flächenbereich der ersten Seite (22a) abdecken.

16. Metalloxidhalbleiter, MOS,-Transistor (21), der Folgendes umfasst:
einen Halbleiterkörper (22), der eine erste und eine zweite Seite (22a, 22b), die einander gegenüberliegen, und einen ersten Leitfähigkeitstyp (N) aufweist;
einen Graben (23) im Halbleiterkörper (22) an der ersten Seite (22a), wobei der Graben (23) eine erste und eine zweite Seite aufweist, die einander gegenüberliegen, wobei die erste und die zweite Seite des Grabens quer zur ersten Seite des Halbleiterkörpers verlaufen und sich in Richtung der zweiten Seite des Halbleiterkörpers entlang einer Richtung (Z) erstrecken;
einen ersten Oxidbereich (24, 26) im Graben an der ersten und der zweiten Seite des Grabens (23);
einen leitfähigen Gate-Bereich (25a) in dem Graben (23) auf dem ersten Oxidbereich (24, 26), wobei der leitfähige Gate-Bereich vom Halbleiterkörper (22) durch den ersten Oxidbereich (24, 26) elektrisch isoliert ist;
einen zweiten Oxidbereich (28) im Graben (23) auf dem leitfähigen Gate-Bereich (25a);
einen ersten und einen zweiten Körperbereich (37) mit einem zweiten Leitfähigkeitstyp (P), der der ersten Seite (22a) des Halbleiterkörpers (22) zugewandt ist und an die jeweilige erste und zweite laterale Seite des Grabens (23) angrenzt, wobei sich der erste Leitfähigkeitstyp vom zweiten Leitfähigkeitstyp unterscheidet;
einen ersten und einen zweiten Source-Bereich (39) mit dem ersten Leitfähigkeitstyp (N) innerhalb des jeweiligen ersten und zweiten Körperbereichs (37) und zur ersten Seite (22a) zugewandt; und
eine Drain-Elektrode an der zweiten Seite (22b),
wobei Abschnitte des ersten und des zweiten Oxidbereichs (24, 26, 28) und des oberen Oxidbereichs (28) an der ersten Seite (22a) teilweise aus dem Halbleiterkörper (22) herausragen,
wobei der MOS-Transistor ferner Folgendes umfasst:
einen ersten und einen zweiten Abstandshalter (34), die an die von der ersten Seite des Halbleiterkörpers (22) herausragenden Abschnitte des ersten Oxidbereichs (24, 26) angrenzen, wobei die Abschnitte des ersten Oxidbereichs (26) zwischen dem zweiten Oxidbereich (28) und dem ersten bzw. dem zweiten Abstandshalter (34) angeordnet sind;
eine erste Vertiefung (40) im Halbleiterkörper (22), die sich durch den ersten Source-Bereich (39) und den ersten Körperbereich (37) erstreckt und an den ersten Abstandshalter (34) angrenzt;
eine zweite Vertiefung (40) im Halbleiterkörper (22), die sich durch den zweiten Source-Bereich (39) und den zweiten Körperbereich (37) erstreckt und an den zweiten Abstandshalter (34) angrenzt;
einen ersten und einen zweiten angereicherten Bereich (41) des zweiten Leitfähigkeitstyps (P) mit einer anderen Dotierungskonzentration als der erste und der zweite Körperbereich, wobei sich der erste und der zweite angereicherte Bereich in der jeweiligen ersten und zweiten Vertiefung (40) befinden, wobei der erste und der zweite angereicherte Bereich in elektrischem Kontakt mit dem ersten bzw. dem zweiten Körperbereich (37) stehen,
**dadurch gekennzeichnet, dass** er ferner Folgendes umfasst:
eine erste Unterschicht (36a) aus einem ersten dielektrischen Material, die auf dem zweiten Oxidbereich (28) liegt und entlang der Richtung (Z) ausgerichtet ist;
eine zweite Unterschicht (36b) aus einem zweiten dielektrischen Material, das sich vom ersten dielektrischen Material unterscheidet, auf der ersten Unterschicht (36a) und auf dieser entlang der Richtung (Z) ausgerichtet;
eine dritte Unterschicht (38b) aus einem dritten dielektrischen Material, das sich vom ersten und zweiten dielektrischen Material unterscheidet, auf der zweiten Unterschicht (36b) und auf dieser entlang der Richtung (Z) ausgerichtet; und
eine Metallkontaktschicht (44) in der ersten und der zweiten Vertiefung (40) in elektrischem Kontakt mit dem ersten und dem zweiten Source-Bereich (39) und auf der ersten, der zweiten und der dritten Unterschicht (36a, 36b, 38b), wobei die erste, die zweite und die dritte Unterschicht (36a, 36b, 38b) zu der ersten und der zweiten Seite des Grabens (23) und zum leitfähigen Gate-Bereich (25a) entlang der Richtung (Z) ausgerichtet sind.

17. MOS-Transistor nach Anspruch 16, der ferner eine vierte Unterschicht (38b) aus einem vierten Material, das sich von dem zweiten dielektrischen Material unterscheidet, und sich zwischen der zweiten und der dritten Unterschicht erstreckend umfasst,
wobei die vierte Unterschicht (38b) entlang der Richtung (Z) zur dritten Unterschicht (38a) ausgerichtet ist.

18. MOS-Transistor nach Anspruch 16 oder 17, wobei das erste dielektrische Material ein Oxid des Halbleitermaterials ist und das zweite dielektrische Material ein Nitrid des Halbleitermaterials ist.

19. MOS-Transistor nach einem der Ansprüche 16-18, wobei die dritte Unterschicht ein Prämetall-Dielektrikum, PMD, ist.

20. MOS-Transistor nach einem der Ansprüche 16-19, wobei das dritte dielektrische Material Borphosphorsilikatglas, BPSG, ist.

21. MOS-Transistor nach Anspruch 17 oder einem der Ansprüche 18-20, wenn abhängig von Anspruch 17, wobei das vierte dielektrische Material ein Oxid des Halbleitermaterials ist.

22. MOS-Transistor nach einem der Ansprüche 16-21, wobei sich die erste und die zweite Seite des Grabens (23) in Bezug auf eine Symmetrieachse (H), die orthogonal zu der ersten und der zweiten Seite (22a, 22b) ist, symmetrisch zueinander erstrecken.

## Revendications

1. Procédé de fabrication d'un transistor MOS (21) comprenant les étapes suivantes :
former une tranchée (23) sur un premier côté (22a) d'un corps semiconducteur (22) en matériau semiconducteur, la tranchée (23) ayant un premier et un deuxième côté opposés l'un à l'autre et s'étendant vers un deuxième côté (22b) du corps semiconducteur (22) ;
remplir la tranchée (23) en formant, dans la tranchée (23), une première région d'oxyde (24, 26), une région de grille conductrice (25a) qui est électriquement isolée du corps semiconducteur (22) par ladite première région d'oxyde (24, 26), et une deuxième région d'oxyde (28) sur la région de grille conductrice (25a), la deuxième région d'oxyde (28) étant physiquement séparée du corps semiconducteur (22) par ladite première région d'oxyde (24, 26) ;
retirer des parties du corps semiconducteur adjacentes aux premier et deuxième côtés de la tranchée ;
former une première et une deuxième région de corps (37) ayant un deuxième type de conductivité (P), les première et deuxième régions de corps (37) étant adjacentes aux premier et deuxième côtés respectifs de la tranchée (23) ;
former une première et une deuxième région de source (39) ayant un premier type de conductivité (N) dans les première et deuxième régions de corps respectives (37), le premier type de conductivité étant différent du deuxième type de conductivité ;
former des première et deuxième entretoises (34) adjacentes aux première et deuxième régions d'oxyde et sur les première et deuxième régions de source ;
former, dans le corps semiconducteur (22), un premier évidement (40) s'étendant à travers ladite première région de source (39) et ladite première région de corps (37) en utilisant ladite première entretoise (34) comme masque de gravure ;
former, dans le corps semiconducteur (22), un deuxième évidement (40) s'étendant à travers ladite deuxième région de source (39) et ladite deuxième région de corps (37) en utilisant ladite deuxième entretoise (34) comme masque de gravure ; et
former des première et deuxième régions enrichies en contact électrique avec les première et deuxième régions de corps respectives, en incluant l'implantation d'espèces dopantes du deuxième type de conductivité (P) dans les premier et deuxième évidements (40) en utilisant lesdites première et deuxième entretoises (34) comme masques d'implantation,
**caractérisé en ce qu'**il comprend, avant les étapes de formation des premier et deuxième évidements (40), les étapes supplémentaires suivantes :
former une première sous-couche (36a ; 236a), faite d'un premier matériau diélectrique, sur la deuxième région d'oxyde (28), sur les première et deuxième entretoises (34) et sur les première et deuxième régions de source (39) ;
former une deuxième sous-couche (36b ; 236b), faite d'un deuxième matériau diélectrique différent du premier matériau diélectrique, sur la première sous-couche (36a ; 236a) ;
former une troisième sous-couche (38b ; 238), faite d'un troisième matériau diélectrique différent des premier et deuxième matériaux diélectriques, sur la deuxième sous-couche (36b ; 236b) ;
modeler la troisième sous-couche (38b ; 238) pour former une troisième sous-région au-dessus de la deuxième région d'oxyde (28) ;
modeler les première et deuxième sous-couches (36a, 36b ; 236a, 236b) en utilisant la troisième sous-région comme masque de modelage, pour former des première et deuxième sous-régions respectives entre la deuxième région d'oxyde (28) et la troisième sous-région ; et
former une couche de contact métallique (44) dans les premier et deuxième évidements (40) pour réaliser un contact électrique avec les première et deuxième régions de source (39), et sur les première, deuxième et troisième sous-régions.

2. Procédé selon la revendication 1, dans lequel le premier matériau diélectrique est un oxyde dudit matériau semiconducteur, et le deuxième matériau diélectrique est un nitrure dudit matériau semiconducteur.

3. Procédé selon la revendication 1 ou 2, dans lequel la troisième sous-couche est un diélectrique prémétallique, ou PMD.

4. Procédé selon l'une quelconque des revendications 1 à 3, dans lequel le troisième matériau diélectrique est du verre borophosphosilicate, ou BPSG.

5. Procédé selon l'une quelconque des revendications 1 à 4, comprenant en outre les étapes suivantes :
avant la formation de la troisième sous-couche (38b), former une quatrième sous-couche (38a), faite d'un quatrième matériau diélectrique différent du deuxième matériau diélectrique, sur la deuxième sous-couche (36b) ; et
modeler la quatrième sous-couche pour former une quatrième sous-région entre la deuxième région d'oxyde (28) et la troisième sous-région (38b),
dans lequel le quatrième matériau diélectrique est un oxyde dudit matériau semiconducteur.

6. Procédé selon la revendication 5, dans lequel les étapes de modelage des troisième et quatrième sous-couches (38a, 38b) comprennent le fait de réaliser une gravure au masque pour retirer sélectivement des parties des troisième et quatrième sous-couches (38a, 38b) s'étendant latéralement à la deuxième région d'oxyde (28).

7. Procédé selon la revendication 6, dans lequel le modelage des troisième et quatrième sous-couches (38a, 38b) comprend en outre le fait de modeler par gravure les troisième et quatrième sous-couches (38a, 38b) sur toute leur épaisseur latéralement par rapport à la deuxième région d'oxyde (28), la deuxième sous-couche (36b) étant une couche d'arrêt de gravure.

8. Procédé selon l'une quelconque des revendications 1 à 4, dans lequel l'étape de modelage de la troisième sous-couche (238) comprend le fait de réaliser une gravure au masque pour retirer sélectivement des parties de la troisième sous-couche s'étendant latéralement par rapport aux première et deuxième entretoises (232) ;
le procédé comprenant en outre les étapes suivantes :
retirer sélectivement des parties des première et deuxième sous-couches (236a, 236b) s'étendant latéralement par rapport aux première et deuxième entretoises (232) ; et
maintenir des parties des première et deuxième sous-couches (236a, 236b) qui couvrent les première et deuxième entretoises (232).

9. Procédé selon l'une quelconque des revendications précédentes, dans lequel les premier et deuxième côtés de la tranchée (23) s'étendent de manière symétrique l'un par rapport à l'autre relativement à un axe de symétrie (H) orthogonal aux premier et deuxième côtés (22a, 22b).

10. Procédé selon la revendication 9, comprenant en outre les étapes suivantes :
former une électrode de drain sur le deuxième côté (22b) du corps semiconducteur (22) ;
après le remplissage de la tranchée (23) et avant la formation des première et deuxième régions de corps (37) et des première et deuxième régions de source (39), réduire une épaisseur du corps semiconducteur (22) en retirant, sur le premier côté (22a), des parties du corps semiconducteur (22) adjacentes aux premier et deuxième côtés de la tranchée (23), de telle manière que la première région d'oxyde (24, 26) et la deuxième région d'oxyde (28) font saillie en partie depuis le corps semiconducteur (22) sur le premier côté (22a) ;
après la formation des première et deuxième régions de corps (37) et des première et deuxième régions de source (39), former lesdites première et deuxième entretoises (34) adjacentes à la région d'oxyde (24, 26) et faisant saillie depuis le corps semiconducteur (22) sur le premier côté (22a), les première et deuxième entretoises (34) étant spéculaires entre elles par rapport audit axe de symétrie (H).

11. Procédé selon l'une quelconque des revendications précédentes, dans lequel l'étape de formation des première et deuxième entretoises (34) comprend les étapes suivantes :
former une couche d'espacement (32) en matériau isolant ou diélectrique sur le premier côté (22a), sur la région d'oxyde (24, 26) faisant saillie depuis le corps semiconducteur (22) et sur la région d'oxyde supérieure (28) ; et
réaliser une étape de gravure sans masque pour retirer des parties de la couche d'espacement (32) s'étendant parallèlement au premier côté (22a).

12. Procédé selon la revendication 11, dans lequel l'étape de gravure sans masque comprend le fait de réaliser une étape de gravure sèche anisotrope configurée pour retirer des parties de la couche d'espacement (32) s'étendant parallèlement au premier côté (22a) et pour préserver d'autres parties de la couche d'espacement (32) s'étendant le long de la première région d'oxyde (24, 26) orthogonalement au premier côté (22a).

13. Procédé selon la revendication 11 ou 12, dans lequel on arrête l'étape de gravure sans masque lorsque la couche d'espacement (32) s'étendant parallèlement au premier côté (22a) est complètement retirée.

14. Procédé selon l'une quelconque des revendications précédentes, dans lequel l'étape de remplissage de la tranchée (23) comprend l'étape supplémentaire consistant à former, dans la tranchée (23) et avant la formation de la région de grille conductrice (25a), une plaque de champ (25b) en matériau électriquement conducteur qui est électriquement isolée du corps semiconducteur (22) par ladite première région d'oxyde (24, 26).

15. Procédé selon l'une quelconque des revendications précédentes, dans lequel les première et deuxième entretoises (34) couvrent une même quantité respective de région de surface du premier côté (22a).

16. Transistor métal-oxyde-semiconducteur, ou MOS (21), comprenant :
un corps semiconducteur (22) ayant un premier et un deuxième côté (22a, 22b) opposés l'un à l'autre et ayant un premier type de conductivité (N) ;
une tranchée (23) dans le corps semiconducteur (22) sur le premier côté (22a), la tranchée (23) ayant un premier et un deuxième côté opposés l'un à l'autre, les premier et deuxième côtés de la tranchée étant transversaux par rapport au premier côté du corps semiconducteur et s'étendant vers le deuxième côté du corps semiconducteur le long d'une direction (Z) ;
une première région d'oxyde (24, 26) dans la tranchée sur les premier et deuxième côtés de la tranchée (23) ;
une région de grille conductrice (25a) dans ladite tranchée (23) sur la première région d'oxyde (24, 26), la région de grille conductrice étant électriquement isolée du corps semiconducteur (22) par ladite première région d'oxyde (24, 26) ;
une deuxième région d'oxyde (28) dans la tranchée (23) sur la région de grille conductrice (25a) ;
une première et une deuxième région de corps (37) ayant un deuxième type de conductivité (P) faisant face au premier côté (22a) du corps semiconducteur (22) et adjacentes aux premier et deuxième côtés latéraux respectifs de la tranchée (23), le premier type de conductivité étant différent du deuxième type de conductivité ;
une première et une deuxième région de source (39) ayant le premier type de conductivité (N) dans les première et deuxième régions de corps respectives (37) et faisant face au premier côté (22a) ; et
une électrode de drain sur le deuxième côté (22b),
dans lequel des parties des première et deuxième régions d'oxyde (24, 26, 28) et de la région d'oxyde supérieure (28) font saillie en partie depuis le corps semiconducteur (22) sur le premier côté (22a),
le transistor MOS comprenant en outre :
des première et deuxième entretoises (34) adjacentes aux parties de la première région d'oxyde (24, 26) faisant saillie depuis le premier côté du corps semiconducteur (22), les parties de la première région d'oxyde (26) étant placées respectivement entre la deuxième région d'oxyde (28) et les première et deuxième entretoises (34) ;
un premier évidement (40) dans le corps semiconducteur (22), s'étendant à travers ladite première région de source (39) et ladite première région de corps (37) adjacente à ladite première entretoise (34) ;
un deuxième évidement (40) dans le corps semiconducteur (22), s'étendant à travers ladite deuxième région de source (39) et ladite deuxième région de corps (37) adjacente à ladite deuxième entretoise (34) ;
des première et deuxième régions enrichies (41) ayant le deuxième type de conductivité (P) avec une concentration de dopage différente de celle des première et deuxième régions de corps, les première et deuxième régions enrichies se trouvant dans les premier et deuxième évidements respectifs (40), les première et deuxième régions enrichies étant en contact électrique respectivement avec les première et deuxième régions de corps (37),
**caractérisé en ce qu'**il comprend en outre :
une première sous-couche (36a), faite d'un premier matériau diélectrique, sur et alignée avec la deuxième région d'oxyde (28) le long de ladite direction (Z) ;
une deuxième sous-couche (36b), faite d'un deuxième matériau diélectrique différent du premier matériau diélectrique, sur et alignée avec la première sous-couche (36a) le long de ladite direction (Z) ;
une troisième sous-couche (38b), faite d'un troisième matériau diélectrique différent du premier matériau diélectrique et du deuxième matériau diélectrique, sur et alignée avec la deuxième sous-couche (36b) le long de ladite direction (Z) ; et
une couche de contact métallique (44) dans les premier et deuxième évidements (40) en contact électrique avec les première et deuxième régions de source (39), et sur les première, deuxième et troisième sous-couches (36a, 36b, 38b), dans lequel les première, deuxième et troisième sous-couches (36a, 36b, 38b) sont alignées avec lesdits premier et deuxième côtés de la tranchée (23) et avec la région de grille conductrice (25a) le long de ladite direction (Z).

17. Transistor MOS selon la revendication 16, comprenant en outre une quatrième sous-couche (38b), faite d'un quatrième matériau diélectrique différent du deuxième matériau diélectrique, s'étendant entre les deuxième et troisième sous-couches,
la quatrième sous-couche (38b) étant alignée avec la troisième sous-couche (38a) le long de ladite direction (Z).

18. Transistor MOS selon la revendication 16 ou 17, dans lequel le premier matériau diélectrique est un oxyde dudit matériau semiconducteur, et le deuxième matériau diélectrique est un nitrure dudit matériau semiconducteur.

19. Transistor MOS selon l'une quelconque des revendications 16 à 18, dans lequel la troisième sous-couche est un diélectrique prémétallique, ou PMD.

20. Transistor MOS selon l'une quelconque des revendications 16 à 19, dans lequel le troisième matériau diélectrique est du verre borophosphosilicate, ou BPSG.

21. Transistor MOS selon la revendication 17, ou l'une quelconque des revendications 18 à 20 lorsqu'elles dépendent de la revendication 17, dans lequel le quatrième matériau diélectrique est un oxyde dudit matériau semiconducteur.

22. Transistor MOS selon l'une quelconque des revendications 16 à 21, dans lequel les premier et deuxième côtés de la tranchée (23) s'étendent de manière symétrique l'un par rapport à l'autre relativement à un axe de symétrie (H) orthogonal aux premier et deuxième côtés (22a, 22b).
